(19) Europäisches Patentamt
European Patent Office
Office européen des brevets

(11) Veröffentlichungsnummer: 0 329 610
A2

(12) # EUROPÄISCHE PATENTANMELDUNG

(21) Anmeldenummer: 89810101.9

(51) Int. Cl.4: G 03 F 7/10

(22) Anmeldetag: 06.02.89

(30) Priorität: 13.02.88 DE 3804533

(43) Veröffentlichungstag der Anmeldung: 23.08.89 Patentblatt 89/34

(84) Benannte Vertragsstaaten: AT BE CH DE FR GB IT LI NL SE

(71) Anmelder: CIBA-GEIGY AG
Klybeckstrasse 141
CH-4002 Basel (CH)

(72) Erfinder: Schulz, Reinhard, Dr.
Im Trappengrund 44
D-6107 Reinheim (DE)

Bartmann, Ekkehard, Dr.
Dieburger Weg 12a
D-6106 Erzhausen (DE)

Münzel, Horst, Dr.
Rüdesheimer Strasse 20
D-6100 Darmstadt (DE)

Wehner, Gregor, Dr.
Reuterallee 12
D-6100 Darmstadt (DE)

(54) **Siliziumhaltige Positiv-Fotoresistzusammensetzungen mit 1,2-Disulfonen.**

(57) Die Erfindung betrifft Positiv-Fotoresistzusammensetzungen, enthaltend in einem organischen Lösungsmittel im wesentlichen mindestens je

a) ein silyliertes Phenolharz

b) einen Sensibilisator sowie gegebenenfalls weitere übliche Zusatzstoffe, die als Sensibilisator eine 1,2-Disulfon-Verbindung der Formel I

$R^1-SO_2-SO_2-R^2$

mit den für $R^1$ und $R^2$ angegebenen Bedeutungen enthalten.

EP 0 329 610 A2

## Beschreibung

### Siliziumhaltige Positiv-Fotoresistzusammensetzungen mit 1,2-Disulfonen

Die Erfindung betrifft siliziumhaltige Positiv-Fotoresistzusammensetzungen mit 1,2-Disulfon-Verbindungen als Sensibilisatoren.

Die Herstellung von Halbleiterbauelementen und integrierten Schaltungen in der Mikroelektronik erfolgt praktisch ausschließlich unter Anwendung photolithographischer Strukturierungsprozesse. Zur Herstellung von bestimmte Schaltungsstrukturen aufweisenden Mikrochips wird das Halbleitersubstratmaterial, im allgemeinen sind das Siliziumscheiben, mit Fotolack beschichtet und durch bildmäßiges Belichten und anschließendes Entwickeln werden hierauf Fotoresist-Reliefstrukturen erzeugt. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Nach diesen Prozessen werden die Fotoresist-Masken je nach Notwendigkeit wieder entfernt. Durch eine Vielzahl derartiger Prozeßzyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozeß abgelöst, während die unbelichteten Bereiche als Schicht auf dem Substrat verbleiben. Bei negativ arbeitenden Fotoresists verbleiben umgekehrt die bestrahlten Schichtbereiche als Reliefstruktur. Positiv-Fotoresists ermöglichen in der Regel eine höhere Bildauflösung und werden deshalb überwiegend bei der Herstellung von VLSI-Schaltungen eingesetzt.

Die ständig fortschreitende Miniaturisierung in der Halbleitertechnologie und Mikroelektronik stellt an die Fotoresist-Materialien und die damit darzustellenden Reliefstrukturen höchste Anforderungen. Neben Empfindlichkeit, Auflösung und Kontrast des Fotoresist sowie Haftfestigkeit, mechanischer und chemischer Stabilität, Dimensionstreue und Beständigkeit bei erhöhten Temperaturen oder anderen Einflüssen, die bei den weiteren Prozeßschritten auf die Fotoresist-Reliefstrukturen einwirken können, kommt der Plasmaätzbeständigkeit des Resistmaterials besondere Bedeutung zu.

Übliche Positiv-Fotoresists auf Basis von alkalilöslichem Novolakharz und strahlungsempfindlichen Chinondiazidverbindungen können praktisch nicht in Prozeßabläufen eingesetzt werden, in denen Plasmaätzschritte vorkommen, da sie selbst in dickerer Schicht keine ausreichende Plasmaätzresistenz aufweisen.

Bei der Realisierung von elektronischen Schaltungsstrukturen im Mikron- und Submikronbereich tritt insbesondere bei nichtplanarer Topographie des Substrates das Problem auf, Fotoresist-Reliefstrukturen mit Linienbreiten von weniger als 1 µm, aber einer Höhe von stellenweise mehr als 1 µm exakt zu erzeugen. Mit einer einlagigen Resistschicht kann dieses Problem nicht zufriedenstellend gelöst werden, da bei nichtplanarer Substrattopographie die Resistschicht unterschiedliche Dicke aufweist und deshalb nach der Fotostrukturierung und Entwicklung nicht tolerierbare Linienbreitenschwankungen zu verzeichnen sind.

Dieses Problem ist dahingehend lösbar, daß man ein 2-Lagenverfahren anwendet, bei dem auf dem Substrat zunächst eine planarisierende Polymerschicht aufgebracht wird, die nicht notwendigerweise fotosensitiv zu sein braucht, und darauf erst die eigentliche, zur Strukturierung zu benutzende Fotoresistschicht. Die strukturierte Fotoresistauflage dient dann als Maske beim anschließenden Trockenätzen im Plasma, bei dem in den resistfreien Bereichen die Planarisierungschicht entfernt und das Substrat freigelegt wird.

Hochauflösende Optiken haben allerdings den Nachteil einer geringen Schärfentiefe, sodaß die obere Fotoresistschicht möglichst dünn gehalten werden muß. Wegen des erforderlichen Trockenätzschrittes muß der Resist aber auch in dünner Schicht eine hohe Plasmaätzstabilität aufweisen, um die Maskierungsfunktion nicht zu verlieren.

Es ist bekannt, daß organische Polymermaterialien, die etwa 5-15 % an Silizium enthalten, eine Plasmaätzresistenz aufweisen, die erheblich höher ist als von Polymeren, die kein Silizium enthalten. Dementsprechend sind bereits verschiedene siliziumhaltige Fotoresists vorgeschlagen worden, die sich auch für die 2-Lagentechnik eignen sollen. Überwiegend sind jedoch derartige Resists, wie etwa solche auf Polysiloxanbasis nur im Bereich hochenergetischer Strahlung wie Tief-UV, Röntgen- oder Elektronenstrahlung empfindlich, was ihre praktische Eignung für die z. Z. üblichen Belichtungsgeräte in der großindustriellen Fertigung weitgehend ausschließt oder zumindest erheblich einschränkt. In jedem Falle erfordern diese Resistsysteme zur Fotostrukturierung sehr hohe Bestrahlungsenergien. Darüber hinaus sind sie nicht, wie übliche Positivresists auf Chinondiazid/Novolakharz-Basis, im wäßrig-alkalischen Entwicklern entwickelbar.

In EP 178 208 sind silylierte Polyvinylphenole und Derivate hiervon beschrieben, die in Verbindung mit fotosensitiven Sulfonium- oder Iodonium-Komplexsalzen und weiteren Sensibilisatoren als im nahen UV verwendbare Fotoresists eingesetzt werden können. Die Komplexsalze enthalten jedoch überwiegend Elemente, die auf Halbleiter materialien dotierend wirken können wie Bor, Phosphor, Arsen oder Antimon, was den Einsatz derartiger Fotoresists in der Halbleitermikroelektronik praktisch ausschließt. Auch werden bei diesen Systemen mit etwa 100 $mJ/cm^2$ noch relativ hohe Belichtungsenergien benötigt. Sie sind weiterhin nicht wäßrig-alkalisch entwickelbar.

Es bestand daher die Aufgabe, siliziumhaltige Positiv-Fotoresists mit für die Halbleiterelektronik anwendungskompatibler Zusammensetzung zu entwickeln, die einerseits im UV-Bereich eine sehr hohe Empfindlichkeit aufweisen und andererseits in wäßrig-alkalischen Entwicklern entwickelbar sind.

Überraschend wurde nun gefunden, daß Positiv-Fotoresistim UV-Bereich eine besonders hohe Empfindlichkeit aufweizusammensetzungen auf Basis von silyliertem Phenolharz sen, wenn sie als Sensibilisator mindestens eine 1,2-Disulfon-Verbindung der Formel I

$R^1-SO_2-SO_2R^2$ (I)

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten, enthalten. Derartige Fotoresists sind darüber hinaus vorzüglich in wäßrig-alkalischen Entwicklern entwickelbar. Weiterhin wurde gefunden, daß sich die Empfindlichkeit derartiger Fotoresists noch weiter steigern läßt, wenn bei ihrer Anwendung bei der Herstellung von Fotoresistreliefstrukturen in den üblichen Prozessablauf zwischen bildmäßiger Belichtung und Entwicklung ein weiterer Schritt eingefügt wird, bei dem die Fotoresistschicht einer Zwischenerhitzung unterzogen wird.

Gegenstand der Erfindung sind somit Positiv-Fotoresistzusammensetzungen, enthaltend in einem organischen Lösungsmittel im wesentlichen mindestens je

a) ein silyliertes Phenolharz,

b) einen Sensibilisator sowie gegebenenfalls weitere übliche Zusatzstoffe, die als Sensibilisator eine 1,2-Disulfon-Verbindung der Formel I enthalten.

Gegenstand der Erfindung ist weiterhin die Verwendung von Verbindungen der Formel I als Sensibilisatoren für Positiv-Fotoresistzusammensetzungen auf Basis silylierter Phenolharze.

Gegenstand der Erfindung ist schließlich ein Verfahren zur Herstellung von Fotoresistreliefstrukturen durch Beschichten eines Substrates mit einer Positiv-Fotoresistzusammensetzung, Trocknen der Schicht bei erhöhter Temperatur, bildmäßiges Belichten der Schicht mit Strahlung aus einem Wellenlängenbereich, in dem die Schicht empfindlich ist, und Entwickeln, mit einem wäßrig-alkalischen Entwickler, wobei eine wie vorstehend charakterisierte siliziumhaltige Positiv-Fotoresistzusammensetzung verwendet wird und wobei insbesondere zur Steigerung der Empfindlichkeit zwischen bildmäßiger Belichtung und Entwicklung die belichtete Schicht einem zusätzlichen Zwischenerhitzungsschritt unterzogen wird.

Die erfindungsgemäßen siliziumhaltigen Positiv-Fotoresistzusammensetzung enthalten in einem organischen Lösungsmittel im wesentlichen mindestens ein silyliertes Phenolharz als Harzkomponente, eine Verbindung der Formel I als Sensibilisator sowie gegebenenfalls weitere übliche Zusatzstoffe.

1,2-Disulfon-Verbindungen der Formel I sind zum großen Teil an sich bereits bekannt. Von einigen 1,2-Bisaryldisulfonen ist zwar auch bekannt, daß sie strahlungsreaktiv sind. Nach JP 58-83844 (CA 101, 63684a) entstehen aus diesen Verbindungen unter Einwirkung von UV-Strahlung freie Radikale. Ihr Einsatz ist demnach bestenfalls als radikalische Strahlungsvernetzer in negativ arbeitenden strahlungsempfindlichen Zusammensetzungen denkbar. Umso erstaunlicher ist der Befund, daß 1,2-Disulfone, insbesondere auch von weitaus breiterer struktureller Vielfalt, vorzüglich geeignet sind als die Entwicklerlöslichkeit unter Einfluß von UV-Strahlung steigernde Sensibilisatoren in Positiv-Forotresists auf Basis von silyliertem Phenolharz.

In Formel I können die Substituenten $R^1$ und $R^2$ gleich oder verschieden sein und Alkyl, Cycloalkyl, Aryl, Aralkyl oder Heteroaryl mit bis zu 12 C-Atomen, gegebenen falls ein- oder mehrfach substituiert mit Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten.

Bevorzugte Reste $R^1$ und $R^2$ sind beispielsweise Methyl, Ethyl, n- und i-Propyl, Cyclohexyl, Phenyl, Benzyl, Pyridyl, Naphthyl, Tolyl, Anisyl, 2,4,6-Trimethylphenyl, 4-Isopropylphenyl, Chlor-, Brom- und Nitrophenyl.

Die Verbindungen der Formel I können im Prinzip alle nach Verfahren hergestellt werden, wie sie für 1,2-Disulfone in der Literatur bereits beschrieben sind. Als ein Syntheseverfahren der Wahl hat sich erwiesen, 1,2-Disulfonylhydrazine, die leicht durch Umsetzung von Hydrazin mit Sulfonsäurechloriden zugänglich sind, mit konzentrierter Salpetersäure als Oxidationsmittel zu den 1,2-Disulfonen der Formel I zu oxidieren. Dieser Syntheseweg ist sehr einfach, erbringt gute Ausbeuten und ermöglicht den Zugang zu praktisch beliebigen Substituentenkombinationen von $R^1$ und $R^2$.

Bevorzugt werden als Sensibilisatoren in den erfindungsgemäßen siliziumhaltigen Positiv-Fotoresistzusammensetzungen symmetrische und insbesondere unsymmetrische 1,2-Disulfon-Verbindungen der Formel I eingesetzt, bei denen $R^1$ und $R^2$ Phenyl, mit Methyl, Methoxy oder Isopropyl substituiertes Phenyl, oder $C_{1-3}$-Alkyl darstellen. Als Beispiele für solche Verbindungen sind besonders hervorzuheben 1,2-Diphenyldisulfon, 1-(4-Methylphenyl)2-phenyldisulfon, 1-(4-Methoxyphenyl)-2-phenyldisulfon, 1-(4-Isopropylphenyl)-2-phenyldisulfon, 1-(4-Methylphenyl)-2-methyldisulfon, 1,2-Di-n-propyldisulfon, 1-(4-Methoxyphenyl)-2-n-propyldisulfon.

Die Verbindungen der Formel I können je nach Natur der Substituenten $R^1$ und $R^2$ in einem Wellenlängenbereich von etwa 200 bis 500 nm als Sensibilisatoren eingesetzt werden. Verbindungen der Formel I, in denen die Substituenten $R^1$ und $R^2$ Phenyl oder niedrig substituiertes Phenyl darstellen sensibilisieren besonders effektiv vornehmlich im tiefen bis mittleren UV-Bereich, etwa zwischen 200 und 280 nm. Durch den Zusatz von in längerwelligen Bereichen absorbierenden Cosensibilisatoren bekannter Art, etwa aromatische Ketone wie Michler's Keton, kann, falls nötig, die Empfindlichkeit der erfindungsgemäßen siliziumhaltigen Positiv-Fotoresists in den nahen UV-Bereich verschoben werden. Eine für die praktische Anwendung ausreichende Sensibilisatorwirkung geht von den Verbindungen der Formel I aus, wenn sie in den erfindungsgemäßen siliziumhaltigen Positiv-Fotoresistzusammensetzungen in einem Anteil von 1 bis 20

Gew.%, vorzugweise 5 bis 15 %, bezogen auf den Gesamtfeststoffgehalt der Fotoresistlösung, enthalten sind.

In den erfindungsgemäßen siliziumhaltigen Positiv-Fotoresistzusammensetzungen wird die Harzkomponente im wesentlichen von einem silylierten Phenolharz gebildet. Als solches kommen in erster Linie Polymere auf Basis von silyliertem Polyvinylphenol in Betracht. Derartige Polymere weisen in der Regel wiederkehrende Einheiten der Struktur II auf

$$-\!\!\left(-CH_2-\underset{\displaystyle O-Si(R^bR^cR^d)}{\underset{|}{CR^a}}-\right)\!\!- \qquad \text{(II)}$$

worin $R^a$ Wasserstoff oder $C_{1-6}$-Alkyl, $R^b$, $R^c$, $R^d$ $C_{1-6}$Alkyl oder Phenyl bedeutet. Silylierte Phenolharze dieser Art sind bekannt und auch in der Fotoresisttechnik als Harzkomponenten gebräuchlich. Zugänglich sind diese Polymere etwa durch Veretherung nach gängigen Methoden der phenolischen Hydroxylgruppen von gebräuchlichem Polyvinylphenol mit Halogensilanverbindungen mit Hilfe starker Basen. Es kann aber auch zunächst monomeres Vinylphenol in entsprechender Weise mit der Halogensilanverbindung umgesetzt und das silylierte Monomer dann in bekannter Weise polymerisiert werden. Vorteilhafter ist allerdings der erstgenannte Weg, da hierbei durch die Wahl des Verhältnisses von Polyvinylphenol zu Silanverbindung in einfacher und genauer Weise der gewünschte Silylierungsgrad, also der Anteil an mit Silan umgesetzten phenolischen Hydroxyl-Gruppen des Polymers eingestellt werden kann.

In den wiederkehrenden Einheiten der Struktur II des silylierten Phenolharzes kann $R^a$ Wasserstoff oder Alkyl mit 1-6 C-Atomen wie beispielsweise Methyl, Ethyl, n-Propyl, n-Butyl, n-Pentyl oder n-Hexyl bedeuten. Bevorzugt als Reste $R^a$ sind Wasserstoff und Methyl, insbesondere Wasserstoff. In der Silyl-Gruppe der Einheit der Struktur II können $R^b$, $R^c$ und $R^d$ gleich oder verschieden sein und Alkyl-Gruppen mit 1-6 C-Atomen sowie die Phenyl-Gruppe darstellen. Als Alkyl-Gruppen kommen Methyl, Ethyl, die isomeren Formen von Propyl, Butyl, Pentyl und Hexyl in Frage. Bevorzugt sind Methyl, Ethyl, n- und i-Propyl, n-und t-Butyl. Besonders bevorzugt ist Methyl.

Silylierte Phenolharze dieser Art sind insbesondere dann als Harzkomponente für Positiv-Fotoresists geeignet, wenn sie mittlere Molmassen im Bereich von etwa 1.500-150.000 aufweisen. Bevorzugt liegen die mittleren Molmassen im Bereich von etwa 3.000-15.000.

Siliziumhaltige Positiv-Fotoresistzusammensetzungen gemäß der Erfindung zeigen insbesondere dann eine vorzügliche Plasmaätzbeständigkeit, wenn das silylierte Phenolharz mit den wiederkehrenden Einheiten der Struktur II einen Silylierungsgrad zwischen 0,3 und 0,9, bezogen auf den Gesamtgehalt an phenolischem Sauerstoff, aufweist. Unterhalb von einem Silylierungsgrad von 0,3 wird die Plasmaätzbeständigkeit ungenügend. Oberhalb eines Silylierungsgrades von 0,9 nimmt die Entwickelbarkeit in wäßrig alkalischen Entwicklern ab. Silylierte Phenolharze mit Silylierungsgraden zwischen 0,5 und 0,75 sind besonders bevorzugt. Silyliertes Phenolharz mit einem Silylierungsgrad über 0,9 kann aber auch eingesetzt werden, wenn es mit anderen alkalilöslichen nicht-siliziumhaltigen Harzen verschnitten wird und der resultierende Gesamt-Siliziumgehalt in der gewünschten Größenordnung liegt.

In den erfindungsgemäßen siliziumhaltigen Positiv-Fotoresistzusammensetzungen hat die Harzkomponente üblicherweise einen Anteil von 80 bis 99 Gew.%, vorzugsweise 85 bis 95 Gew.%, bezogen auf den Gesamtfeststoffgehalt der Fotoresistlösung. Neben dem silylierten Phenolharz konnen als Harzkomponente auch andere alkalilösliche Harze enthalten sein, wie zum Beispiel Novolakharze, die durch Kondensation von Phenol bzw. phenolischen Verbindungen mit Aldehyden erhalten werden. Bevorzugt sind Kresol-Formaldehydharze, zu deren Herstellung o-, m-, p-Kresol oder Mischungen dieser Isomeren in beliebigen oder vorbestimmten Verhältnissen eingesetzt werden. Darüberhinaus kommen gegebenenfalls noch in Frage Polyvinylphenole und Polyglutarimide, Copolymere aus Styrol und α-Methylstyrol mit Maleinimid sowie Copolymere aus N-(p-Hydroxyphenyl)maleinimid und Olefinen. Weiterhin können auch silylierte Derivate solcher alkalilöslicher Polymere verwendet werden, die eine höhere Plasmaätzbeständigkeit aufweisen.

Als Lösungsmittel zur Herstellung der Fotoresist-Lösung sind im Prinzip alle Lösungsmittel geeignet, in denen die festen Fotoresist-Bestandteile wie siliziumhaltige Harzkomponente, Verbindung(en) der Formel I und gegebenenfalls weitere Zusatzstoffe ausreichend löslich sind und die mit diesen Bestandteilen nicht irreversibel reagieren. In Frage kommen hierfur beispielsweise aliphatische Ketone wie Methylethylketon oder Cyclohexanon, aliphatische Ester wie Butylacetat, Ether wie Tetrahydrofuran, Alkohole wie n- oder i-Propanol, Mono- oder Bisether sowie gemischte Ether-Esterderivate von Glycolverbindungen wie von Ethylenglycol, Diethylenglycol oder Propylenglycol, des weiteren Monooxocarbonsäureester wie etwa Milchsäureethylester oder 2-Ethoxypropionsäureethylester. Aliphatische und aromatische Kohlenwasserstoffe wie n-Hexan und Xylol finden ebenfalls Verwendung als Lösungsmittel. Vielfach werden auch Gemische aus den genannten Lösungsmitteln verwendet. Verbreitet enthalten Fotoresist-Lösungsmittel Ethoxyethylacetat, Methoxypropylacetat oder Ethylenglycoldimethylether. Das Lösungsmittel hat üblicherweise einen Anteil von 40-90 Gew.% an der gesamten Fotoresist-Lösung.

Zu den weiteren üblichen Zusatzstoffen, die gegebenenfalls auch in den erfindungsgemäßen siliziumhaltigen Fotoresistzusammensetzungen enthalten sein können, gehören die Fotoempfindlichkeit steigernde Verbindungen, wie strahlungsempfindliche Chinondiazidverbindungen oder Arylketon-Sensibilisatoren, und/oder die Entwicklungsrate steigernde Verbindungen, etwa aromatische Hydroxyverbindungen wie Polyhydroxybenzophenone oder Benzotriazolderivate, sowie streustrahlungsabsorbierende Substanzen und Farbstoffe, Verlaufmittel, Weichmacher, Haftvermittler, weitere filmbildende Harze, Tenside und Stabilisatoren. usätze dieser Kategorien sind dem Fachmann ausreichend bekannt und sind vielfältig in der einschlägigen Fachliteratur beschrieben. Der Anteil an solchen Zusätzen Zübersteigt zusammengenommen kaum 25 Gew.%, bezogen auf den Gesamtfeststoffgehalt der Fotoresist-Lösung.

Die Formulierung der erfindungsgemäßen Positiv-Fotoresistzusammensetzungen erfolgt in an sich bekannter Weise durch Mischen bzw. Lösen der Komponenten in dem Lösungsmittel bzw. Lösungsmittelgemisch. Nach Lösung der Bestandteile im Lösungsmittel wird die erhaltene Fotoresist-Lösung je nach Anspruch an die Partikelfreiheit durch Membranfilter mit einer Porenweite von 0,1-1 µm filtriert. Üblicherweise wird der Gesamtfeststoffgehalt des Fotoresist auf die gewünschte Schichtdicke und Beschichtungsmethode abgestimmt.

Die erfindungsgemäßen siliziumhaltigen Positiv-Fotoresistzusammensetzungen lassen sich besonders vorteilhaft bei der Erzeugung von Halbleiterstrukturen im Mikron- und Submikronbereich unter Anwendung von Plasmaätztechniken und hierbei insbesondere auf nicht-planaren Substraten mittels der 2-Lagentechnik einsetzen.

Die Anwendung erfolgt nach an sich bekannten Verfahren und mit den hierfür üblichen Prozeßgeräten durch Beschichten eines Substrates mit der Positiv-Fotoresistzusammensetzung, Trocknen der Schicht bei erhöhter Temperatur, bildmäßiges Belichten der Schicht mit Strahlung aus einem Wellenlängenbereich, in dem die Schicht empfindlich ist, und Entwickeln mit einem wäßrig-alkalischen Entwickler.

Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere bei der Herstellung miniaturisierte Schaltungen übliche Materialien wie Germanium, Galliumarsenid, Keramik mit gegebenenfalls Edelmetallbeschichtung kommen in Frage.

Haben diese Substrate bereits Strukturierungs- und Funktionalisierungsschritte durchlaufen, so weisen sie vielfach eine nicht-planare Topographie auf. Bei Anwendung der 2-Lagentechnik wird auf die Oberfläche zunächst nach üblichen Techniken eine planarisierende Polymerschicht aufgebracht, deren Dicke je nach Topographie typisch im Bereich zwischen etwa 1 und 4 µm liegt. Als Polymermaterialien für die Planarisierungsschicht kommen praktisch alle anwendungskompatiblen Polymere, die sich im Sauerstoffplasma rückstandslos entfernen lassen, in Frage. Bevorzugt werden hierbei Formulierungen auf Novolakharz-Basis eingesetzt, die nicht notwendigerweise fotosensitiv zu sein brauchen. Es können aber auch strahlungsempfindliche Polymerformulierungen, wie etwa übliche Positiv-Fotoresists zur Erzeugung der Planarisierungsschicht eingesetzt werden. Auf die Planarisierungsschicht wird dann in möglichst dünner Schicht der erfindungsgemäße siliziumhaltige Fotoresist aufgebracht.

Die Beschichtung erfolgt üblicherweise durch Tauchen, Sprühen, Walzen oder Aufschleudern. Bei der letzteren, am häufigsten angewandten Beschichtungsmethode ist die resultierende Schichtdicke abhängig von der Viskosität der Fotoresist-Lösung, dem Feststoffgehalt und der Aufschleudergeschwindigkeit. Für den jeweiligen Fotoresist werden sogenannte Schleuderkurven ermittelt, aus denen sich die Resist-Schichtdicken in Abhängigkeit von Viskosität und Schleuderdrehzahl ermitteln lassen. Die Schichtdicken für siliziumhaltige Positiv-Fotoresists liegen typisch im Bereich von 0,1-1 µm, insbesondere 0,2-0,5 µm.

Nachdem der Fotoresist auf das Substrat aufgebracht worden ist, wird er normalerweise bei Temperaturen zwischen 70 °C und 130 °C vorgetrocknet. Dazu können Öfen oder Heizplatten (sogenannte "Hot Plates") verwendet werden. Die Trocknungszeit in Öfen liegt im Bereich von etwa 15-45 Minuten, auf Heizplatten im Bereich von etwa 0,5-4 Minuten. Vorzugsweise wird etwa 1 Minute bei etwa 100 °C auf der Heizplatte getrocknet.

Der getrocknete Fotoresist wird dann durch eine Maske hindurch bildmäßig belichtet, wobei UV-Strahlung vorzugsweise mit einer Wellenlänge im Bereich von etwa 200 nm bis 280 nm verwendet wird. Die Belichtung kann poly- oder monochromatisch erfolgen. Bevorzugt werden hierzu kommerziell erhältliche Geräte, wie z.B. Scanning-Projektions-Belichtungsgeräte, Kontakt- und Abstands-Belichtungsgeräte oder Wafer-Stepper eingesetzt.

Die erfindungsgemäßen siliziumhaltigen Positiv-Fotoresistzusammensetzungen zeigen eine sehr hohe Empfindlichkeit. Bei normaler Anwendung liegt ihre Empfindlichkeit erheblich unter 100 $mJ/cm^2$, in der Regel zwischen etwa 35 und 70 $mJ/cm^2$. Eine weitere Steigerung der Empfindlichkeit bis herab zu etwa 20 $mJ/cm^2$ ist möglich, wenn der belichtete Fotoresist vor der Entwicklung einem Zwischenerhitzungsschritt unterzogen wird. Dieser Zwischenerhitzungsschritt erfolgt im Prinzip nach den Bedingungen des Vortrocknens. Bevorzugt wird bei 100 bis 120 °C 1 Minute auf der Heizplatte erhitzt.

Die mit dem Fotoresist beschichteten und belichteten Substrate werden schließlich mit einer wäßrig-alkalischen Entwicklerlösung, z.B. durch Tauchen oder Besprühen, entwickelt, bis in den belichteten Bereichen der Resist vollständig abgelöst ist. Es können verschiedene Entwicklerformulierungen verwendet werden, die entweder zur Klasse der metallionenhaltigen oder metallionenfreien Fotoresistentwickler gehören. Metallionenhaltige Entwickler sind wäßrige Lösungen von Natriumhydroxyd oder Kaliumhydroxid, die daüber hinaus pH-regulierende und puffernde Substanzen, wie Phosphate oder Silikate sowie Tenside und

Stabilisatoren enthalten können. Metallionenfreie Entwickler enthalten statt alkalischer Metallverbindungen organische Basen, wie z.B. Tetramethylammoniumhydroxyd oder Cholin. Die Entwicklungszeiten hängen von der Belichtungsenergie, Stärke des Entwicklers, Art des Entwickelns, der Vortrocknungstemperatur und der Entwicklertemperatur ab. Bei der Tauchentwicklung sind Entwicklungszeiten von etwa 1 Minute typisch. Die Entwicklung wird üblicherweise durch Eintauchen oder Besprühen mit deionisiertem Wasser gestoppt. An die Entwicklung schließt sich häufig eine Nachtrocknung bei etwa 120 °C bis 180 °C an.

In den Bereichen, in denen der Fotoresist durch Entwicklung entfernt worden ist, kann nun durch anisotropes Trockenätzen im Sauerstoffplasma unter hierfür üblichen Bedingungen das planarisierende Polymer entfernt und die Substratober fläche freigelegt werden, wobei die mit dem erfindungsgemäßen siliziumhaltigen Fotoresist erzeugte Bildsturktur als Ätzmaske dient.

Die Plasmaätzbeständigkeit der mit Hilfe der erfindungsgemäßen siliziumhaltigen Positiv-Fotoresistzusammensetzungen hergestellten Schichten ist vorzüglich. Die so erzeugten Reliefstrukturen ermöglichen eine abbildungsgetreue Strukturübertragung mit einer Auflösung bis unter 1 µm bei hohem Kontrast, hoher Kantensteilheit und Kantenschärfe. Aufgrund der hohen Empfindlichkeit gegenüber UV-Strahlung insbesondere im Bereich von etwa 200-280 nm, der problemlosen Entwickelbarkeit in wäßrig alkalischen Entwicklern sowie der Abwesenheit dotierend wirkender und daher in der Halbleiterelektronik unerwünschter Elemente, ist der Wert der erfindungsgemäßen siliziumhaltigen Positiv-Fotoresistzusammensetzungen in der praktischen Anwendung gegenüber üblichen Fotoresists erheblich verbessert.

## Beispiele

A. Allgemeine Vorschrift zur Herstellung von 1,2-Disulfonen der Formel $R^1-SO_2-SO_2-R^2$ (I)

Zur entsprechenden 1,2-Disulfonylhydrazinverbindung wird unter Rühren und Eiskühlung konzentrierte Salpetersäure (Dichte 1,4) getropft. Die Reaktion setzt nach einigen Minuten unter Stickstoffentwicklung ein. Nach Abklingen der Reaktion wird noch etwa 1 Stunde bei 0 °C gerührt, der ausgefallene Niederschlag abgetrennt und zur Reinigung umkristallisiert.

B. Hergestellte Verbindungen

| Nr. | $R^1$ | $R^2$ | Umkristallisiert aus | Schmelzpunkt (°C) |
|---|---|---|---|---|
| 1 | Phenyl | Phenyl | Ethanol | 192 |
| 2 | " | 4-Methylphenyl | Methanol | 177 |
| 3 | " | 4-Methoxyphenyl | Aceton | 153 |
| 4 | " | 2-Naphthyl | Methyl-t-Butyl-ether | 182 |
| 5 | " | Benzyl | Methyl-t-Butyl-ether/Aceton | 186 |
| 6* | " | 2-Nitro-3,5-dimethoxyphenyl | Aceton | 186 |
| 7 | " | 2,4,6-Trimethyl-phenyl | Toluol | 154 |
| 8 | " | 4-i-Propylphenyl | Eisessig | 92 |
| 9 | " | 4-Chlorphenyl | Toluol | 181 |
| 10 | " | 4-Bromphenyl | Aceton | 198 |
| 11 | 4-Methylphenyl | 4-Methylphenyl | Aceton/Ether | 222 |
| 12 | " | 4-Chorphenyl | Toluol | 206 |
| 13 | " | Benzyl | Methanol | 126 |

| | | | | |
|---|---|---|---|---|
| 14 | 4-Methylphenyl | 2-Naphthyl | Methyl-t-Butylether/Dichlormethan | 186 |
| 15 | " | 4-Methoxyphenyl | Aceton | 173 |
| 16* | " | 2-Nitro-3,5-dimethoxyphenyl | Aceton | 182 |
| 17 | " | Methyl | Methyl-t-Butylether | 109 |
| 18 | " | 1-Naphthyl | Aceton | 201 |
| 19 | 1-Naphthyl | 1-Naphthyl | Aceton/DMF | 183 (Zersetzung) |
| 20 | 2-Naphthyl | 2-Naphthyl | THF | 226 (Zersetzung) |
| 21 | 4-Methoxyphenyl | 4-Methoxyphenyl | Aceton | 194 (Zersetzung) |
| 22 | 4-Nitrophenyl | 4-Nitrophenyl | THF | 224 (Zersetzung) |
| 23 | 2-Methylphenyl | 2-Methylphenyl | Toluol | 160 |
| 24 | Benzyl | Benzyl | Eisessig | 183 (Zersetzung) |
| 25 | Benzyl | n-Propyl | Dichlormethan/n-Pentan | 100 |
| 26 | n-Propyl | n-Propyl | (Wasser)** | 53 |
| 27 | n-Propyl | 4-Nitrophenyl | Methyl-t-Butylether | 111 |
| 28 | n-Propyl | 4-Methoxyphenyl | Petrolether | 83 |
| 29 | Phenyl | n-Propyl | Methyl-t-Butylether | 138 |
| 30 | " | 4-t-Butylphenyl | (Wasser)** | 128 |
| 31 | 4-Methylphenyl | n-Propyl | (Wasser)** | 86 |
| 32 | 4-i-Propylphenyl | Methyl | - | (Öl) |
| 33 | 4-t-Butylphenyl | n-Propyl | Ether/Petrolether | 110 |

| | | | | |
|---|---|---|---|---|
| 34 | 1-Naphthyl | Methyl | Toluol | 157 |
| 35 | 1-Naphthyl | n-Propyl | (Wasser)** | 116 |
| 36 | 2-Naphthyl | Methyl | (Wasser)** | 146 |
| 37 | 2-Naphthyl | n-Propyl | Ether/Petrolether | 67 |
| 38 | 4-Acetylamido-phenyl | n-Propyl | Eisessig | 189 |
| 39 | " | Phenyl | " | 208 |
| 40 | " | 4-Methylphenyl | " | 201 |
| 41 | " | 4-Methoxyphenyl | " | 204 |
| 42 | " | 4-Nitrophenyl | " | 198 (Zer-setzung) |
| 43 | 4-Phthalimido-phenyl | n-Propyl | " | 196 |
| 44 | " | Phenyl | Dichlormethan/ Cyclohexan | 210 |
| 45 | " | 4-Methylphenyl | Eisessig | 214 |
| 46 | " | 4-Methoxyphenyl | " | 162 |
| 47 | 4-(1,2-Di-methylmalein-imido)phenyl | n-Propyl | Methyl-t-butylether | 143 |
| 48 | " | Phenyl | Dichlormethan | 222 |
| 49 | " | 4-Methylphenyl | Dichlormethan/ Petrolether | 235 |
| 50 | " | 4-Methoxyphenyl | Eisessig | 162 |
| 51 | 4-Nitrophenyl | n-Propyl | Ether | 104 |

* Die Einführung der $NO_2$-Gruppe erfolgte hier während der Salpetersäure-Oxidation

** Kristallisiert bereits bei Zugabe von Wasser in ausreichender Reinheit aus

C. Allgemeine Vorschrift zur Herstellung von silyliertem Phenolharz

Polyvinylphenol wird unter Rückfluß in Ethanol gelöst und mit der für den gewünschten Umsetzungs grad erforderlichen Menge an Natriumethylat in Ethanol versetzt. Danach wird die für den gewünschten Silylierungsgrad erforderliche Menge an Halogensilan zugetropft und bis zur vollständigen Umsetzung unter Rückfluß erhitzt. Durch Einrühren des Reaktionsgemisches in 2%ige wäßrige Salzsäure wird das silylierte Phenolharz als pulvriges Produkt gefällt. Dieses wird abfiltriert, neutral gewaschen und getrocknet.

D. Herstellung und Anwendung von Fotoresistzusammensetzungen

Beispiel 1

9,0 g eines nach C. aus Polyvinylphenol und Trimethylchlorsilan hergestellten silylierten Phenolharzes mit einer mittleren Molmasse von 3500 und einem Silylierungsgrad von 0,6 wurden mit 1,2 g 1-(4-Isopropylphenyl)-2-phenyldisulfon (Verbindung Nr. 8) in 20,0 g Methoxypropylacetat gelöst. Die Lösung wurde dann auf einen Feststoffgehalt von 32 Gew.% eingestellt und durch ein Filter mit 0,2 µm Porenweite filtriert.

Die Fotoresist-Formulierung wurde auf oberflächlich oxidierte Silizium-Scheiben von 4″ Durchmesser bei einer Drehzahl von etwa 5000 $min^{-1}$ aufgeschleudert, sodaß nach dem Trocknen auf der Hot Plate für 1 Minute bei 100 °C eine Schichtdicke von 1,1 µm resultierte.

Die Belichtung erfolgt für 125 Sekunden durch eine Auflösungstestmaske im Kontaktverfahren (Gerät: Süss MA 56, Hg-Hochdrucklampe), wobei die Belichtungsenergie bei 260 nm mit einer Meßsonde regi striert wurde. Entwickelt wurde durch Tauchentwicklung 1 Minute lang bei 20 °C in 2%iger wäßriger Tetramethylammoniumhydroxid-Lösung.

Bei einer Belichtungsenergie von 36 $mJ/cm^2$, gemessen bei 260 nm, waren 1 µm große Strukturen maskengetreu abgebildet.

Beispiel 2

Es wurde wie in Beispiel 1 verfahren, jedoch wurde der beschichtete Wafer nach der Belichtung 1 Minute bei 120 °C auf der Heizplatte erhitzt.

Die für eine exakte Wiedergabe von 1 µm großen Strukturen erforderliche Belichtungsenergie betrug hier nur noch 22 $mJ/cm^2$ (bei 260 nm).

Beispiel 3

Analog zu Beispiel 1 wurde aus 9,0 g eines aus Polyvinylphenol und Trimethylchlorsilan erhaltenen silylierten Phenolharzes einer mittleren Molmasse von 6700 und einem Silylierungsgrad von 0,6, 0,9 g 1-(4-Methylphenyl)-2-phenyldisulfon (Verbindung Nr. 2) und 20,0 g Methoxypropylacetat eine Fotoresistlösung formuliert und in gleicher Weise angewendet.

Bei einer Belichtungsenergie von 50 $mJ/cm^2$, gemessen bei 260 nm, waren 1 µm große Strukturen maskengetreu abgebildet.

Beispiel 4

Analog zu Beispiel 1 wurde aus 9,0 g eines aus Polyvinylphenol und Trimethylchlorsilan erhaltenen silylierten Phenolharzes einer mittleren Molmasse von 6700 und einem Silylierungsgrad von 0,6, 0,9 g 1-(4-Methoxyphenyl)-2-phenyldisulfon (Verbindung Nr. 3) und 20,0 g Methoxypropylacetat eine Fotoresistlösung formuliert und in gleicher Weise angewendet.

Bei einer Belichtungsenergie von 70 $mJ/cm^2$, gemessen bei 260 nm, waren 1 µm große Strukturen maskengetreu abgebildet.

**Patentansprüche**

1. Positiv-Fotoresistzusammensetzungen, enthaltend in einem organischen Lösungsmittel im wesentlichen mindestens je
a) ein silyliertes Phenolharz,
b) einen Sensibilisator
sowie gegebenenfalls weitere übliche Zusatzstoffe, dadurch gekennzeichnet, daß sie als Sensibilisator eine 1,2-Disulfon-Verbindung der Formel I
$R^1\text{-}SO_2\text{-}SO_2\text{-}R^2$ (I)
worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino Alkanoyl, Alkanoyloxy, Alkanoylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten, enthalten.

2. Positiv-Fotoresistzusammensetzungen nach Anspruch 1, dadurch gekennzeichnet, daß darin die Verbindung(en) der Formel I in einem Anteil von 1-20 Gew.%, vorzugsweise 5-15 Gew.%, bezogen auf den Gesamtfeststoffgehalt, enthalten ist (sind).

3. Verwendung von Verbindungen der Formel I als Sensibilisatoren für Positiv-Fotoresistzusammensetzungen auf Basis silylierter Phenolharze.

4. Verfahren zur Herstellung von Fotoresistreliefstrukturen durch Beschichten eines Substrates mit einer Positiv-Fotoresistzusammensetzung, Trocknen der Schicht bei erhöhter Temperatur, bildmäßiges Belichten der Schicht mit Strahlung aus einem Wellenlängenbereich, in dem die Schicht empfindlich ist, und Entwickeln mit einem wäßrig-alkalischen Entwickler, dadurch gekennzeichnet, daß als Positiv-Fotoresistzusammensetzung eine Zusammensetzung nach Anspruch 1 verwendet wird.

5. Verfahren nach Anspruch 4, dadurch gekennzeichnet, daß die belichtete Schicht vor der Entwicklung einem Zwischenerhitzungsschritt unterzogen wird.